# EUROPEAN PATENT APPLICATION

(11) **EP 1 628 334 A1**
(43) Date of publication of application: **22.02.2006**
(21) Application number: 04731712.8
(22) Date of filing: 07.05.2004
(51) Int. Cl.: H01L 21/304

(54) **POLISHING LIQUID FOR CMP PROCESS AND POLISHING METHOD**

(30) Priority: 09.05.2003 JP 2003131406; 13.06.2003 JP 2003168596
(71) Applicant: SANYO CHEMICAL INDUSTRIES LTD., Kyoto 605 (JP); ADVANCED TECHNOLOGY MATERIALS, INC., Danbury, CT 06810 (US)
(72) Inventor: NAKANO, Tomoharu, SANYO CHEMICAL INDUSTRIES, Ltd., Higashiyama-ku, Kyoto-shi Kyoto 6050995 (JP); NAKAJIMA, Fumihiro, SANYO CHEMICAL INDUSTRIES,Ltd., Higashiyama-ku, Kyoto-shi Kyoto 6050995 (JP); MIYAZAKI, Tadakazu, SANYO CHEMICAL INDUSTRIES,Ltd., Higashiyama-ku, Kyoto-shi Kyoto 6050995 (JP); BROWN, Duncan, (US); HEALY, Matthew D., (US)
(74) Representative: Morf, Jan Stefan
(86) International application number: PCT/JP2004/006027
(87) International publication number: WO 2004/100242

(57) **Abstract**

An abrasive liquid for CMP process characterized by comprising an abrasive material, an aqueous solvent and an addition agent, and containing abrasive particles having a particle diameter of 20 to 80 nm by 15 weight % or more on the basis of the weight of the abrasive liquid; and a method of polishing by using the abrasive liquid are appropriate for the processing of flattening the surface of a device wafer on which at least a silicon oxide film is formed, and take effect of being capable of stably performing superior abrasive properties such as flattening properties, low flaw properties and high washing properties, and then are the most appropriate for the processing of flattening the surface of a semiconductor device comprising a layer insulation film or an element separation film, a magnetic head and a substrate for a liquid crystal display in the semiconductor industry.

## Description

### TECHNICAL FIELD

The present invention relates to an abrasive liquid for CMP process, more detailedly to an abrasive liquid for CMP process on the occasion of manufacturing a semiconductor device, and particularly to an abrasive liquid for CMP process used for the step of flattening a layer insulation film, the step of forming a buried layer of shallow trench element separation, capacitor and metal wiring in a trench and the step of forming a magnetic head.

### BACKGROUND ART

A technique such that a high-molecular anionic surface active agent is used for an abrasive liquid has been conventionally known in CMP process for the purpose of improving flatness after polishing (Japanese Unexamined Patent Publication No. 2001-57353). With regard to this technique, the active agent interacts with a device wafer and/or an abrasive material before polishing, and polishing is progressed by surpassing this interaction with an abrasive pressure of a certain value or more. The abrasive pressure is relatively applied with difficulty to the recess of a device wafer on which surface a pattern is formed, so that the height of a patterned wafer is selectively polished to intend to develop a superior flatness.

Incidentally, CMP is a polishing method for flattening by removing a difference in level of a pattern formed on the surface of a device wafer and signifies mechanochemical polishing (Chemical Mechanical Planarization) in which chemical polishing and mechanical polishing are combined.

In this method, however, polishing is not progressed without a high abrasive pressure, whereby many flaws remain on a wafer after polishing to notably deteriorate the efficiency percentage of a device wafer.

Also, the problem is that the aggregation of an abrasive material is easily caused in mixing a high-molecular anionic surface active agent and an abrasive liquid to have dispersion in abrasive properties; a high-molecular anionic surface active agent easily remains on the surface of a workpiece even after washing to have no improvement in the efficiency percentage of a device wafer; two liquids of a high-molecular anionic surface active agent and an abrasive material need to be mixed immediately before polishing to have a low workability; and the like.

A first object of the present invention is to provide an abrasive liquid for CMP process, which is capable of stably performing superior abrasive properties such as flattening properties, low flaw properties and high washing properties.

A second object of the present invention is to provide a polishing method, which is capable of stably performing superior abrasive properties.

A third object of the present invention is to provide a material polished by using the abrasive liquid or using the polishing method.

That is to say, the present invention is an invention with the following aspects [1] to [4].
[1] An abrasive liquid for CMP process characterized by comprising an abrasive material, an aqueous solvent and an addition agent, and containing abrasive particles having a particle diameter of 20 to 80 nm by 15 weight % or more on the basis of the weight of the abrasive liquid
[2] A method of polishing by using the abrasive liquid
[3] A layer insulation film, an element separation film or a magnetic head obtained by polishing with the use of the abrasive liquid
[4] A semiconductor device comprising the layer insulation film or the element separation film

### DISCLOSURE OF THE INVENTION

### (An Abrasive Liquid for CMP Process)

An abrasive liquid for CMP process of the present invention essentially contains particles having a abrasive particle diameter in a range of 20 to 80 nm by 15 weight % or more on the basis of the weight of the abrasive liquid, preferably contains particles having a particle diameter in a range of 30 to 70 nm by 10 weight % or more on the basis of the weight of the abrasive liquid, and particularly preferably contains particles having a particle diameter in a range of 40 to 60 nm by 5 weight % or more on the basis of the weight of the abrasive liquid. When particles having a particle diameter in a range of 20 to 80 nm are less than 15 weight % on the basis of the weight of the abrasive liquid, superior flattening properties are developed with difficulty after polishing.

All particle diameters in the present invention are values on the number basis measured by a capillary type particle-size distribution measuring device. A particle-size distribution measuring method in capillary method can be performed by using a particle-size distribution measuring device CHDF-2000 manufactured by MATEC APPLIED SCIENCES COR.

### (A measuring method in the case of using CHDF-2000)

An abrasive liquid to be measured is diluted with ion exchange water by 10 to 20 times to be filtered with a 0.5-µm filter and injected into a particle-size distribution measuring device with an approximately 1-ml microsyringe, and thereafter shifted in a capillary column at a pressure of 3500 psi and a flow rate of 1.4 ml/minute to separate particles and measure particle diameter and concentration by using a UV detector with a wavelength of 220 nm.

A range of particle diameter in the total abrasive materials is preferably 1 to 250 nm, more preferably 20 to 100 nm. Among them, it is essential to contain particles having a particle diameter in a range of 20 to 80 nm by 15 weight % or more; also, preferably 80 weight % or less, more preferably 60 weight % or less on the basis of the weight of the abrasive liquid. A method of containing many particles having a particle diameter in a range of 20 to 80 nm in an abrasive material involves a method of rendering colloidal and fumed by a manufacturing method such as ion exchange method, solution chemical reaction method and flame oxidation method, and is not limited thereto.

Particularly preferably, colloidal silica by ion exchange method or solution chemical reaction method contains many particles having a particle diameter in a range of 20 to 80 nm.

The quality of an abrasive material to be used can involve both of organic powders and inorganic powders. The powders may be used singly or together in two kinds or more.

The organic powders involve epoxy resin powders, urethane resin powders, vinyl resin powders, polyester, benzoguanamine resin powders, silicone resin powders, novolac resin powders, phenolic resin powders, and the like. With regard to these resin powders, molecular weight, hardness and the like are not particularly limited.

The inorganic powders involve metallic oxide, metallic nitride, and the like.

The metallic oxide involves metallic oxide of 4A family, 3B family, 4B family and lanthanoide series of 3A family in the long-period type periodic table of element, for example, zirconium oxide, aluminum oxide, silicon dioxide, cerium oxide and the like.

The metallic nitride involves metallic nitride of 4A family, 3B family, 4B family and lanthanoide series in the periodic table of element, for example, zirconium nitride, aluminum nitride, silicon nitride, cerium nitride and the like.

The inorganic powders may be used in one kind or two kinds or more selected from the group consisting of the above-mentioned inorganic powders.

Among these abrasive materials, inorganic powders are preferable, metallic oxide is more preferable, and silicon dioxide is particularly preferable.

The form of abrasive particles is not particularly limited; specifically involving, in the case of zirconium oxide, monoclinic system, tetragonal system, amorphous substance and fumed substance (fumed zirconia); in the case of aluminum oxide, α-, δ-, θ-, κ-alumina and fumed substance (fumed alumina); in the case of silicon dioxide, colloidal and fumed substance; in the case of cerium oxide, hexagonal system, isometric system and face-centered cubic system; and in the case of silicon nitride, α-, β- and amorphous silicon nitride, which form is not limited thereto. The form is preferably fumed, particularly colloidal.

An addition agent in the present invention preferably involves a basic substance having a pKa of 7 to 11 at a temperature of 25°C, and the like, more preferably a basic substance having a pKa of 7.5 to 10.5, and particularly preferably a pKa of 8 to 10. A pKa of 7 or more at a temperature of 25°C develops superior flattening properties, while a pKa of 11 or less develops superior washing properties. The added quantity is preferably 0.01 to 10 weight % on the basis of the weight of the abrasive liquid, more preferably 0.05 to 5 weight %. When the added quantity of a basic substance is 0.01 weight % or more on the basis of the weight of the abrasive liquid, superior flattening properties are developed, while 10 weight % or less, superior washing properties are developed. Here, pKa denotes a logarithmic value of ionization constant of a basic substance in water at a temperature of 25°C.

An addition agent as a basic substance having a pKa of 7 to 11 involves, for example, ammonia and an amino compound.

The amino compound involves the following fatty amine, alicyclic amine, aromatic amine, polyamide polyamine, polyether polyamine, epoxy-added polyamine, cyanoethylated polyamine, quaternary ammonium salt, amino alcohol, and other amine.
(1) Fatty amines (preferably, a carbon number of 2 to 18, a functional group number of 1 to 7 and a molecular weight of 60 to 500);
   (i) Fatty amines with an amino group number of 1;
      monoalkylamine with a carbon number of 1 to 8 (such as isopropylamine and isobutylamine), dialkyl amine with a carbon number of 2 to 12 (such as dipropylamine, di-isopropylamine, dibutylamine, di-isobutylamine, dipropylammonium hydroxide and di-isopropylammonium hydroxide), trialkylamine with a carbon number of 3 to 16 (such as triethylamine, tripropylamine, tri-isopropylamine and tri-isobutylamine), and the like;
   (ii) Fatty amines with an amino group number of 2 to 7 or more (preferably, a carbon number of 2 to 18 and a molecular weight of 60 to 500);
      alkylenediamine with a carbon number of 2 to 6 (such as ethylenediamine, propylenediamine, trimethylenediamine, tetramethylenediamine and hexamethylenediamine), polyalkylene (a carbon number of 2 to 6) polyamine [such as diethylenetriamine, iminobispropylamine, bis(hexamethylene)triamine, triethylenetetramine, tetraethylenepentamine and pentaethylenehexamine], and the like;
   (iii) Alkyl (a carbon number of 1 to 4) or hydroxyalkyl (a carbon number of 2 to 4) substitution product of (ii) [such as dialkyl (a carbon number of 1 to 3) aminopropylamine, N,N'-dimethylhexamethylenediamine, 2,5-diniethylhexamethylenediamine and methyliminobispropylamine];
   (iv) Aromatic fatty amines (preferably, a carbon number of 8 to 15) (such as xylylenediamine and tetrachlor-para-xylylenediamine);
(2) Alicyclic polyamine (preferably, a carbon number of 4 to 15 and a functional group number of 2 or 3);
   1,3-diaminocyclohexane, isophoronediamine, 4,4'-methylenedicyclohexanediamine, and the like;
(3) Heterocyclic polyamine (preferably, a carbon number of 4 to 15 and a functional group number of 2 or 3);
   piperazine, N-aminoethylpiperazine, 1,4-diaminoethylpiperazine, 1,4-bis(2-amino-2-methylpropyl)piperazine, [such as 3,9-bis(3-aminopropyl)-2,4,8,10-tetraoxaspiro[5,5]undecane], and the like;
(4) Aromatic polyamine (preferably, an amino group number of 2 to 7 and a carbon number of 6 to 20);
   unsubstituted aromatic polyamine, for example, 1,2-, 1,3- and 1,4-phenylenediamine, 2,4'- and 4,4'-diphenylmethanediamine, crude diphenylmethanediamine [polyphenyl polymethylene polyamine], diaminodiphenyl sulfone, benzidine, thiodianiline, bis(3,4-diaminophenyl)sulfone, 2,6-diaminopyridine, meta-aminobenzylamine, triphenylmethane-4,4',4"-triamine, and naphthylenediamine;
   aromatic polyamine having a nucleus-substituted alkyl group (for example, an alkyl group with a carbon number of 1 to 4 such as methyl, ethyl, n- and i-propyl and butyl), for example, 2,4- and 2,6-tolylenediamine, crude tolylenediamine, diethyltolylenediamine, 4,4'-diamino-3,3'-dimethyldiphenylmethane, 4,4'-bis(ortho-toluidine), dianisidine, diaminoditolyl sulfone, 1,3-dimethyl-2,4-diaminobenzene, 1,3-diethyl-2,4-diaminobenzene, 1,3-dimethyl-2,6-diaminobenzene, 1,4-diethyl-2,5-diaminobenzene, 1,4-diisopropyl-2,5-diaminobenzene, 1,4-dibutyl-2,5-diaminobenzene, 2,4-diaminomesitylene, 1,3,5-triethyl-2,4-diaminobenzene, 1,3,5-triisopropyl-2,4-diaminobenzene, 1-methyl-3,5-diethyl-2,4-diaminobenzene, 1-methyl-3,5-diethyl-2,6-diaminobenzene, 2,3-dimethyl-1,4-diaminonaphthalene, 2,6-dimethyl-1,5-diaminonaphthalene, 2,6-diisopropyl-1,5-diaminonaphthalene, 2,6-dibutyl-1,5-diaminonaphthalene, 3,3',5,5'-tetramethylbenzidine, 3,3',5,5'-tetraisopropylbenzidine, 3,3',5,5'-tetramethyl-4,4'-diaminodiphenylmethane, 3,3',5,5'-tetraethyl-4,4'-diaminodiphenylmethane, 3,3',5,5'-tetraisopropyl-4,4'-diaminodiphenylmethane, 3,3',5,5'-tetrabutyl-4,4'-diaminodiphenylmethane, 3,5-diethyl-3'-methyl-2',4-diaminodiphenylmethane, 3,5-diisopropyl-3'-methyl-2',4-diaminodiphenylmethane, 3,3'-diethyl-2,2'-diaminodiphenylmethane, 4,4'-diamino-3,3'-dimethyldiphenylmethane, 3,3',5,5'-tetraethyl-4,4'-diaminobenzophenone, 3,3',5,5'-tetraisopropyl-4,4'-diaminobenzophenone, 3,3',5,5'-tetraethyl-4,4'-diaminodiphenyl ether, 3,3',5,5'-tetraisopropyl-4,4'-diaminodiphenyl sulfone, and a mixture of these isomers at various ratios;
   aromatic polyamine having a nucleus-substituted electron attractive group (for example, halogen such as Cl, Br, I and F, an alkoxy group such as a methoxy group and an ethoxy group, and a nitro group), for example, methylenebis-ortho-chloroaniline, 4-cliloro-ortho-phenylenediamine, 2-chlor-1,4-phenylenediamine, 3-amino-4-chloroaniline, 4-bromo-1,3-phenylenediamine, 2,5-dichlor-1,4-phenylenediamine, 5-nitro-1,3-phenylenediamine, 3-dimethoxy-4-aminoaniline, 4,4'-diamino-3,3'-dimethyl-5,5'-dibromo-diphenylmethane, 3,3'-dichlorobenzidine, 3,3'-dimethoxybenzidine, bis(4-amino-3-chlorophenyl)oxide, bis(4-amino-2-chlorophenyl)propane, bis(4-amino-2-chlorophenyl)sulfone, bis(4-amino-3-methoxyphenyl)decane, bis(4-aminophenyl)sulfide, bis(4-aminophenyl)telluride, bis(4-aminophenyl)selenide, bis(4-amino-3-methoxyphenyl)disulfide, 4,4'-methylenebis(2-iodoaniline), 4,4'-methylenebis(2-bromoaniline), 4,4'-methylenebis(2-fluoroaniline), and 4-aminophenyl-2-chloroaniline;
   aromatic polyamine having a secondary amino group [such that -NH₂ of the above-mentioned aromatic polyamines is partially or totally substituted with -NH-R' (R' is an alkyl group, for example, a lower alkyl group such as methyl and ethyl)], for example, 4,4'-di(methylamino)diphenylmethane, and 1-methyl-2-methylamino-4-aminobenzene;
(5) Polyamide polyamine;
   polyamide polyamine (a number-average molecular weight of 200 to 1000) obtained by a condensation of dicarboxylic acid (such as dimer acid) and excessive (2 mol of primary or secondary amino group with respect to 1 mol of acid) polyamines (such as the above-mentioned alkylenediamine and polyalkylene polyamine with a functional group number of 2 to 7), and the like;
(6) Polyether polyamine (an amino group number; preferably, 2 to 7);
   hydride (a molecular weight of 230 to 1,000) of cyanoethylated product of polyether polyol (an OH number; preferably, 2 to 7), and the like;
(7) Epoxy-added polyamine;
   epoxy-added polyamine (a molecular weight of 230 to 1,000) obtained by adding 1 to 30 mol of epoxy compound [the above-mentioned polyepoxide (B1) and monoepoxide (b) described in Japanese Unexamined Patent Publication No. 2001-40331] to polyamines (such as the above-mentioned alkylenediamine and polyalkylene polyamine), and the like;
(8) Cyanoethylated polyamine;
   cyanoethylated polyamine (a molecular weight of 230 to 606) obtained by an addition reaction of acrylonitrile and polyamines (such as the above-mentioned fatty polyamine) (such as biscyanoethyldiethylenetriamine), and the like;
(9) Other polyamine compounds;
   (i) Hydrazines (such as hydrazine and monoalkyl (a carbon number of 1 to 5) hydrazine);
   (ii) Dihydrazides (fatty dihydrazide with a carbon number of 4 to 30 such as succinic acid dihydrazide and adipic acid dihydrazide; and aromatic dihydrazide with a carbon number of 10 to 40 such as isophthalic acid dihydrazide and terephthalic acid dihydrazide);
   (iii) Guanidines (alkylguanidine with a carbon number of 1 to 5 such as butylguanidine; and cyanoguanidine such as 1-cyanoguanidine);
   (iv) Dicyandiamide, and the like;
      further, a mixture of these of two kinds or more
(10) Quaternary ammonium salt of amidines;
   The above-mentioned quaternary ammonium cation involves the following. Counter anion involves halogen ion, carboxylic anion, sulfonic anion, phosphoric anion and the like, and is not limited thereto.
   (i) Imidazolinium with a carbon number of 3 to 30 or more;
      1,2,3-trimethylimidazolinium, 1,2,3,4-tetramethylimidazolinium, 1,3,4-trimethyl-2-ethylimidazolinium, 1,3-dimethyl-2,4-diethylimidazolinium, 1,2-dimethyl-3,4-diethylimidazolinium, 1,2-dimethyl-3-ethylimidazolinium, 1-ethyl-3-methylimidazolinium, 1-methyl-3-ethylimidazolinium, 1,2,3,4-tetraethylimidazolinium, 1,2,3-triethylimidazolinium, 4-cyano-1,2,3-trimethylimidazolinium, 2-cyanomethyl-1,3-dimethylimidazolinium, 4-acetyl-1,2,3-trimethylimidazolinium, 3-acetylmethyl-1,2-dimethylimidazolinium, 4-methylcarboxymethyl-1,2,3-trimethylimidazolinium, 3-methoxy-1,2-dimethylimidazolinium, 4-formyl-1,2,3-trimethylimidazolinium, 4-formyl-1,2-dimethylimidazolinium, 3-hydroxyethyl-1,2,3-trimethylimidazolinium, 3-hydroxyethyl-1,2-dimethylimidazolinium, and the like;
   (ii) Imidazolium with a carbon number of 3 to 30 or more;
      1,3-dimethylimidazolium, 1-ethyl-3-methylimidazolium, 1-methyl-3-ethylimidazolium, 1,2,3-trimethylimidazolium, 1,2,3,4-tetramethylimidazolimn, 1,3-dimethyl-2-ethylimidazolium, 1,2-dimethyl-3-ethylimidazolium, 1-ethyl-3-methylimidazolium, 1-methyl-3-ethylimidazolium, 1,2,3-triethylimidazolium, 1,2,3,4-tetraethylimidazolium, 1,3-dimethyl-2-phenylimidazolium, 1,3-dimethyl-2-benzylimidazolium, 1-benzyl-2,3-dimethylimidazolium, 4-cyano-1,2,3-trimethylimidazolium, 3-cyanomethyl-1,2-dimethylimidazolium, 4-acetyl-1,2,3-trimethylimidazolium, 3-acetylmethyl-1,2-dimethylimidazolium, 4-carboxymethyl-1,2,3-trimethylimidazolium, 4-methoxy-1,2,3-trimethylimidazolium, 4-formyl-1,2,3-trimethylimidazolium, 3-formylmethyl-1,2-dimethylimidazolium, 3-hydroxyethyl-1,2-dimethylimidazolium, 2-hydroxyethyl-1,3-dimethylimidazolium, N,N'-dimethylbenzoimidazolium, N,N'-diethylbenzoimidazolium, N-methyl-N'-ethylbenzoimidazolium, and the like;
   (iii) Tetrahydropyrimidinium with a carbon number of 4 to 30 or more;
      1,3-dimethyltetrahydropyrimidinium, 1,2,3-trimethyltetrahydropyrimidinium, 1,2,3,4-tetramethyltetrahydropyrimidinium, 8-methyl-1,8-diazabicyclo[5,4,0]-7-undecenium, 5-methyl-1,5-diazabicyclo[4,3,0]-5-nonenium, 4-cyano-1,2,3-trimethyltetrahydropyrimidinium, 3-cyanomethyl-1,2-dimethyltetrahydropyrimidinium, 4-acetyl-1,2,3-trimethyltetrahydropyrimidinium, 3-acetylmethyl-1,2-dimethyltetrahydropyrimidinium, 4-methylcarboxymethyl-1,2,3-trimethyltetrahydropyrimidinium, 4-methoxy-1,2,3-trimethyltetrahydropyrimidinium, 3-methoxymethyl-1, 2-dimethyltetrahydropyrimidinium, 4-hydroxymethyl-1,2,3-trimethyltetrahydropyrimidinium, 4-hydroxymethyl-1,3-dimethyltetrahydropyrimidinium, and the like;
   (iv) Dihydropyrimidinium with a carbon number of 4 to 30 or more;
      1,3-dimethyl-2,4- or -2,6-dihydropyrimidinium [These are denoted as 1,3-dimethyl-2,4,(6)-dihydropyrimidinium, and hereinafter denoted similarly], 1,2,3-trimethyl-2,4,(6)-dihydropyrimidinium, 1,2,3,4-tetramethyl-2,4,(6)-dihydropyrimidinium, 1,2,3,5-tetramethyl-2,4,(6)-dihydropyrimidinium, 8-methyl-1,8-diazacyclo[5,4,0]-7,9(10)-undecanedienium, 5-methyl-1,5-diazacyclo[4,3,0]-5,7(8)-nonadienium, 2-cyanomethyl-1,3-dimethyl-2,4,(6)-dihydropyrimidinium, 3-acetylmethyl-1,2-dimethyl-2,4,(6)-dihydropyrimidinium, 4-methylcarboxymethyl-1,2,3-trimethyl-2,4,(6)-dihydropyrimidinium, 4-methoxy-1,2,3-trimethyl-2,4,(6)-dihydropyrimidinium, 4-formyl-1,2,3-trimethyl-2,4,(6)-dihydropyrimidinium, 3-hydroxymethyl-1,2-dimethyl-2,4,(6)-dihydropyrimidinium, 2-hydroxymethyl-1,3-dimethyl-2,4,(6)-dihydropyrimidinium, and the like;
   (v) Guanidium having imidazolinium skeleton with a carbon number of 3 to 30 or more;
      2-dimethylamino-1,3,4-trimethylimidazolinium, 2-diethylamino-1,3,4-trimethylimidazolinium, 2-diethylamino-1,3-dimethyl-4-ethylimidazolinium, 2-dimethylamino-1-methyl-3,4-diethylimidazolinium, 2-diethylamino-1,3,4-triethylimidazolinium, 2-dimethylamino-1,3-dimethylimidazolinium, 2-diethylamino-1,3-dimethylimidazolinium, 2-diethylamino-1,3-diethylimidazolinium, 1,5,6,7-tetrahydro-1,2-dimethyl-2H-imide[1,2a]imidazolinium, 1,5,6,7-tetrahydro-1,2-dimethyl-2H-pyrimide[1,2a]imidazolinium, 1,5-dihydro-1,2-dimethyl-2H-pyrimide[1,2a]imidazolinium, 2-dimethyl-3-cyanomethyl-1-methylimidazolinium, 2-dimethylamino-3-methylcarboxymethyl-1-methylimidazolinium, 2-dimethylamino-3-methoxymethyl-1-methylimidazolinium, 2-dimethylamino-4-formyl-1,3-dimethylimidazolinium, 2-dimethylamino-3-hydroxyethyl-1-methylimidazolinium, 2-dimethylamino-4-hydroxymethyl-1,3-dimethylimidazolinium, and the like;
   (vi) Guanidium having imidazolium skeleton with a carbon number of 3 to 30 or more;
      2-dimethylamino-1,3,4-trimethylimidazolium, 2-diethylamino-1,3,4-trimethylimidazolium, 2-diethylamino-1,3-dimethyl-4-ethylimidazolium, 2-diethylamino-1-methyl-3,4-diethylimidazolium, 2-diethylamino-1,3,4-triethylimidazolium, 2-dimethylamino-1,3-dimethylimidazolium, 2-dimethylamino-1-ethyl-3-methylimidazolium, 2-diethylamino-1,3-diethylimidazolium, 1,5,6,7-tetrahydro-1,2-dimethyl-2H-imide[1,2a]imidazolium, 1,5,6,7-tetrahydro-1,2-dimethyl-2H-pyrimide[1,2a]imidazolium, 1,5-dihydro-1,2-dimethyl-2H-pyrimide[1,2a]imidazolium, 2-dimethylamino-3-cyanomethyl-1-methylimidazolium, 2-dimethylamino-acetyl-1,3-dimethylimidazolium, 2-dimethylamino-4-methylcarboxymethyl-1,3-dimethylimidazolium, 2-dimethylamino-4-methoxy-1,3-dimethylimidazolium, 2-dimethylamino-3-methoxymethyl-1-methylimidazolium, 2-dimethylamino-3-formylmethyl-1-methylimidazolium, 2-dimethylamino-4-hydroxymethyl-1,3-dimethylimidazolium, and the like;
   (vii) Guanidium having tetrahydropyrimidinium skeleton with a carbon number of 4 to 30 or more;
      2-dimethylamino-1,3, 4-trimethyltetrahydropyrimidi nium, 2-diethylamino-1,3,4-trimethyltetrahydropyrimidinium, 2-diethylamino-1,3-dimethyl-4-ethyltetrahydropyrimidinium, 2-diethylamino-1-methyl-3,4-diethyltetrahydropyrimidinium, 2-dimethylamino-1,3-dimethyltetrahydropyrimidinium, 2-diethylamino-1,3-dimethyltetrahydropyrimidinium, 2-diethylamino-1,3-diethyltetrahydropyrimidinium, 1,3,4,6,7,8-hexahydro-1,2-dimethyl-2H-imide[1,2a]pyrimidinium, 1,3,4,6,7,8-hexahydro-1,2-dimethyl-2H-pyrimide[1,2a]pyrimidinium, 2,3,4,6-tetrahydro-1,2-dimethyl-2H-pyrimide[1,2a]pyrimidinium, 2-dimethylamino-3-cyanomethyl-1-methyltetrahydropyrimidinium, 2-dimethylamino-4-acetyl-1,3-dimethyltetrahydropyrimidinium, 2-dimethylamino-4-methylcarboxymethyl-1,3-dimethyltetrahydropyrimidin ium, 2-dimethylamino-3-methylcarboxymethyl-1-methyltetrahydropyrimidinium, 2-dimethylamino-3-methoxymethyl-1-methyltetrahydropyrimidinium, 2-dimethylamino-4-formyl-1, 3-dimethyltetrahydropyrimidinium, 2-dimethylamino-3-hydroxyethyl-1-methyltetrahydropyrimidinium, 2-dimethylamino-4-hydroxymethyl-1,3-dimethyltetrahydropyrimidinium, and the like;
   (viii) Guanidium having dihydropyrimidinium skeleton with a carbon number of 4 to 30 or more;
      2-dimethylamino-1,3,4-trimethyl-2,4(6)-dihydropyrimidinium, 2-diethylamino-1,3,4-trimethyl-2,4(6)-dihydropyrimidinium, 2-dimetliylamino-1-methyl-3,4-diethyl-2,4(6)-dihydropyrimidinium, 2-diethylamino-1-methyl-3,4-diethyl-2,4(6)-dihydropyrimidinium, 2-diethylamino-1,3,4-triethyl-2,4(6)-dihydropyrimidinium, 2-diethylamino-1,3-dimethyl-2,4(6)-dihydropyrimidinium, 2-diethylamino-1,3-dimethyl-2,4(6)-dihydropyrimidinium, 2-dimethylamino-1-ethyl-3-methyl-2,4(6)-dihydropyrimidinium, 1,6,7,8-tetrahydro-1,2-dimethyl-2H-imide[1,2a]pyrimidinium, 1,6-dihydro-1,2-dimethyl-2H-imide[1,2a]pyrimidinium, 1,6-dihydro-1,2-dimethyl-2H-pyrimide[1,2a]pyrimidinium, 2-dimethylamino-4-cyano-1,3-dimethyl-2,4(6)-dihydropyrimidinium, 2-dimethylamino-4-acetyl-1,3-dimethyl-2,4(6)-dihydropyrimidinium, 2-dimethylamino-3-acetylmethyl-1-methyl-2,4(6)-dihydropyrimidinium, 2-dimethylamino-3-methylcarboxymethyl-1-methyl-2,4(6)-dihydropyrimidi nium, 2-dimethylamino-4-methoxy-1,3-dimethyl-2,4(6)-dihydropyrimidinium, 2-dimethylamino-4-formyl-1,3-dimethyl-2,4(6)-dihydropyrimidinium, 2-dimethylamino-3-formylmethyl-1-methyl-2,4(6)-dihydropyrimidinium, 2-dimethylamino-4-hydroxymethyl-1,3-dimethyl-2,4(6)-dihydropyrimidiniu m, and the like;
(11) Amino alcohol (an amino group number; 1, an OH group number; 1 to 3);
   alkanolamines with a carbon number of 2 to 12, for example, mono-, di- and tri-alkanolamine (such as monoethanolamine, monoisopropanolamine, monobutanolamine, triethanolamine and tripropanolamine); alkyl (a carbon number of 1 to 4) substitution product of these [N,N-dialkylmonoalkanolamine (such as N,N-dimethylethanolamine and N,N-diethylethanolamine), and N-alkyldialkanolamine (such as N-methyldiethanolamine and N-butyldiethanolamine); and nitrogen atom quaternated product of these by a quaternating agent such as dimethylsulfuric acid or benzyl chloride;
   Among these, ammonia, fatty amines, alicyclic polyamines, heterocyclic polyamines and aromatic polyamines are preferable, more preferable ammonia and fatty amines, and particularly preferable ammonia and fatty amines having a primary amino group.

An aqueous solvent in the present invention signifies a solvent consisting essentially of water, for which solvent water and a mixed solvent comprising water and an organic solvent can be used. The organic solvent to be used is preferably alcohol with a carbon number of 1 to 3 (such as methanol, ethanol and isopropanol), ether with a carbon number of 2 to 4 (such as dimethyl ether and diethyl ether), ketone with a carbon number of 3 to 6 (such as acetone and methyl isobutyl ketone), and a mixture of these. Among these, alcohol with a carbon number of 1 to 3 (such as methanol, ethanol and isopropanol) is more preferable.

In the case of using the organic solvent, the content of the organic solvent is preferably 0.0000001 to 10 weight % on the basis of the weight of an aqueous solvent, more preferably 0.00001 to 3 weight %, and particularly preferably 0.001 to 1 weight %.

The content of an aqueous solvent is preferably 50 weight % or more on the basis of the weight of an abrasive liquid, more preferably 52 weight % or more, particularly preferably 55 weight % or more, and most preferably 60 weight % or more; also, preferably 99.9 weight % or less, more preferably 99 weight % or less, particularly preferably 97 weight % or less, and most preferably 95 weight % or less.

An abrasive liquid for CMP process of the present invention is compounded from the above-mentioned abrasive material, aqueous solvent and addition agent in specific quantities, and the following can be further added thereto as required: publicly known rust preventive, surface-active agent, and other addition agent (such as chelating agent, pH adjustor, preservative and antifoaming agent).

The rust preventive to be used is a rust preventive typically used for an abrasive material for CMP process; for example, involving fatty or alicyclic amine with a carbon number of 2 to 16 (alkylamine such as octylamine; oleylamine; cycloalkylamine such as cyclohexylamine; and the like) and an ethyleneoxide (1 to 2 mol) adduct thereof, alkanolamine (such as monoethanolamine, diethanolamine and monopropanolamine) and an ethyleneoxide (1 to 2 mol) adduct thereof; a salt of fatty carboxylic acid (such as oleic acid and stearic acid) and alkali metal or alkaline earth metal; sulfonic acid (such as petroleum sulfonate); phosphate (such as lauryl phosphate), silicate such as calcium silicate, phosphate such as sodium phosphate, potassium phosphate and sodium polyphosphate, nitrite such as sodium nitrite, benzotriazole such as 1,2,3-benzotriazole and carboxybenzotriazole, and the like. Also, these may be used together in two kinds or more. In the case of adding the rust preventive, the content of the rust preventive is preferably 0.01 weight % or more on the basis of the weight of an abrasive liquid, more preferably 0.05 weight % or more, and particularly preferably 0.1 weight % or more; also, preferably 5 weight % or less, more preferably 3 weight % or less, and particularly preferably 2 weight % or less.

The surface-active agent to be used is a nonionic surface-active agent, an anionic surface-active agent and an amphoteric surface-active agent.

The nonionic surface-active agent involves an aliphatic alcohol (a carbon number of 8 to 24) alkylene oxide (a carbon number of 2 to 8 in the alkylene) adduct (the degree of polymerization = 1 to 100), a (poly)oxyalkylene (a carbon number of 2 to 8 in the alkylene, the degree of polymerization = 1 to 100) higher fatty acid (a carbon number of 8 to 24) ester [such as polyethylene glycol monostearate (the degree of polymerization = 20) and polyethylene glycol distearate (the degree of polymerization = 30)], a polyhydric (dihydric to decahydric or more) alcohol (a carbon number of 2 to 10) fatty acid (a carbon number of 8 to 24) ester [such as glyceryl monostearate, ethylene glycol monostearate, sorbitan monolaurate and sorbitan dioleate], a (poly)oxyalkylene (a carbon number of 2 to 8 in the alkylene, the degree of polymerization = 1 to 100) polyhydric (dihydric to decahydric or more) alcohol (a carbon number of 2 to 10) higher fatty acid (a carbon number of 8 to 24) ester [such as polyoxyethylene (the degree of polymerization = 10) sorbitan monolaurate and polyoxyethylene (the degree of polymerization = 50) methyl glucoside dioleate], a (poly)oxyalkylene (a carbon number of 2 to 8 in the alkylene, the degree of polymerization = 1 to 100) alkyl (a carbon number of 1 to 22) phenyl ether, 1:1 type coconut oil fatty diethanolamide and an alkyl (a carbon number of 8 to 24) dialkyl (a carbon number of 1 to 6) amine oxide [such as lauryl dimethylamine oxide], and the like.

The anionic surface-active agent involves hydrocarbon carboxylic acid with a carbon number of 8 to 24 or a salt thereof [such as (poly)oxyethylene (the degree of polymerization = 1 to 100) sodium lauryl ether acetate and (poly)oxyethylene (the degree of polymerization = 1 to 100) disodium lauryl sulfosuccinate], a hydrocarbon sulfate salt with a carbon number of 8 to 24 [such as sodium lauryl sulfate, (poly)oxyethylene (the degree of polymerization = 1 to 100) sodium lauryl sulfate, (poly)oxyethylene (the degree of polymerization = 1 to 100) lauryl triethanolamine sulfate and (poly)oxyethylene (the degree of polymerization = 1 to 100) coconut oil fatty sodium monoethanolamide sulfate], hydrocarbon sulfonate with a carbon number of 8 to 24 [such as sodium dodecylbenzenesulfonatel, a hydrocarbon phosphate salt with a carbon number of 8 to 24 [such as sodium lauryl phosphate], others [such as (poly)oxyethylene (the degree of polymerization = 1 to 100) disodium lauroyl ethanolamide sulfosuccinate, coconut oil fatty methyltaurine sodium, coconut oil fatty sarcosine sodium, coconut oil fatty sarcosine triethanolamine, N-coconut oil fatty acyl-L-glutamic triethanolamine, N-coconut oil fatty acyl-sodium L-glutamate, and lauroylmethyl-β-alanine sodium], and the like.

Also, an alkali metal salt of a polymer (the degree of polymerization = 2 to 200) such as acrylic acid and methacrylic acid is usable.

The amphoteric surface-active agent involves a betaine-type amphoteric surface-active agent [such as coconut oil fatty amide propyldimethylbetaine, lauryldimethylbetaine, 2-alkyl-N-carboxymethyl-N-hydroxyethylimidazoliniumbetaine, laurylhydroxysulfobetaine, an amino acid-type amphoteric surface-active agent [such as sodium β-laurylaminopropionate], and the like.

In the case of adding the surface-active agent, the content of the surface-active agent is preferably 0.01 weight % or more on the basis of the weight of an abrasive liquid, more preferably 0.05 weight % or more, and particularly preferably 0.1 weight % or more; also, preferably 5 weight % or less, more preferably 3 weight % or less, and particularly preferably 1 weight % or less.

The chelating agent involves sodium polyacrylate, sodium ethylenediaminetetraacetate, sodium succinate, 1-hydroxyethane-1,1-sodium diphosphonate, and the like.

The pH adjustor involves acids such as acetic acid, boric acid, citric acid, oxalic acid, phosphoric acid and hydrochloric acid; alkalis such as sodium hydroxide and potassium hydroxide; and the like.

The preservative involves alkyldiaminoethyl glycine hydrochloride, and the like.

The antifoaming agent involves a silicone antifoaming agent, a long-chain alcohol antifoaming agent, a fatty acid ester antifoaming agent, a polyoxyalkylene antifoaming agent, a metallic soap antifoaming agent, and the like.

In the case of adding these other addition agents (such as chelating agent, pH adjustor, preservative and antifoaming agent), the content of these is preferably 0.001 weight % or more on the basis of the weight of an abrasive liquid, more preferably 0.05 weight % or more, and particularly preferably 0.01 weight % or more; also, preferably 10 weight % or less, more preferably 5 weight % or less, and particularly preferably 2 weight % or less.

It is preferred that a method of manufacturing an abrasive liquid for CMP process of the present invention is to compound each raw material. A disperser (such as a homogenizer, an ultrasonic disperser, a ball mill and a bead mill) can be also used in addition to a usual agitator, and temperature and time are not limited; however, the temperature in manufacturing is preferably 5°C or more and 40°C or less.

A method of using an abrasive liquid for CMP process of the present invention is to stock in a slurry tank and supply from this slurry tank to the vicinity of an abrasive head by using a metering pump, and typically use by 50 to 500 ml per minute. A usual polyurethane foam is usable for a pad. Publicly known devices and conditions are applicable to polishing devices and abrasive conditions.

An abrasive liquid for CMP process after polishing can be recycled, which can be refined by a filtering method and the like on that occasion.

### (A Polishing Method)

A polishing method of the present invention is a polishing method of a device wafer by using an abrasive liquid for CMP process comprising an abrasive material, an aqueous solvent and an addition agent, and containing abrasive particles having a particle diameter of 20 to 80 nm by 15 weight % or more; also, preferably 80 weight % or less, more preferably 60 weight % or less on the basis of the weight of the abrasive liquid. The polishing method is preferably a polishing method comprising the step of polishing by two stages or more with polishing conditions changed, which method employs an abrasive liquid for CMP process of the present invention at any of the stages.

Here, with regard to a stage, the change of the conditions in a step signifies a shift to next stage, and rotating equipments need not always to be stopped at every stage. A second stage and further includes the case of definite change of the conditions, such that a second stage and further is performed after a first stage is finished, as well as the case of continuous change of the conditions. The polishing method preferably comprises two to three stages, more preferably two stages. The continuous change of the conditions signifies a multistage case. The step of polishing by an abrasive liquid for CMP process of the present invention is not particularly specified in the stages, preferably at a first stage.

The polishing method is not particularly limited at a first stage and in a second stage and further, which method is preferably performed under one or two conditions or more among the following conditions.
(1) To differentiate the quality of an abrasive material to be used between a first stage and a second stage and further
(2) To use an abrasive liquid, such that an abrasive liquid at a first stage is diluted by 1.1 to 100 times, as an abrasive liquid in a second stage and further
(3) To make into 0.1 to 10.0 the ratio [(r1)/(r2)] of the average particle diameter (r1) of an abrasive material used at a first stage to the average particle diameter (r2) of an abrasive material used in a second stage and further
(4) To make into 0.3 to 5.0 the ratio [(p1)/(p2)] of the pressure (p1) applied on a semiconductor substrate in polishing at a first stage to the pressure (p2) applied on a semiconductor substrate in polishing in a second stage and further
(5) To make into 0.2 to 2.0 the ratio [(t1)/(t2)] of the rotational speed (t1) of a surface plate in polishing at a first stage to the rotational frequency (t2) of a surface plate in polishing in a second stage and further

In the case of (1), the quality of an abrasive material is such as described above, among which an abrasive material of any of two kinds or more can be selected. It is preferable to use colloidal silica at any of the stages, more preferable to use colloidal silica at a first stage. In this case, an abrasive material to be used in a second stage and further is preferably silicon dioxide or organic powders except for colloidal silica. The use of different abrasive materials between a first stage and a second stage and further allows the flawless surface of a polished substance to be efficiently obtained and additionally the surface of a polished substance with a greatly superior washing efficiency to be efficiently obtained.

In the case of (2), it is more preferable to use an abrasive liquid, such that an abrasive liquid at a first stage is diluted by 1.1 to 80 times, as an abrasive liquid in a second stage and further, particularly preferable 1.1 to 50 times, and most preferable 1.1 to 10 times. The use of an abrasive liquid, such that an abrasive liquid at a first stage is diluted by 1.1 to 100 times, as an abrasive liquid in a second stage and further allows the flawless surface of a polished substance to be efficiently obtained and additionally the surface of a polished substance with a greatly superior washing efficiency to be efficiently obtained.

In the case of (3), [(r1)/(r2)] is more preferably 0.2 to 8.0, particularly preferably 0.3 to 6.0, and most preferably 0.5 to 4.0. [(r1)/(r2)] in a range of 0.1 to 10.0 allows the flawless surface of a polished substance to be efficiently obtained and additionally the surface of a polished substance with a greatly superior washing efficiency to be efficiently obtained.

In the case of (4), [(p1)/(p2)] is more preferably 0.35 to 4.5, particularly preferably 0.4 to 4.0, which values of [(p1)/(p2)] is allowed by adjusting pressure in pressurizing an abrasive pad. The pressure in polishing at a first stage is not limited, preferably 60 kPa or less, and the pressure in this range allows a flawless substrate to be obtained. [(p1)/(p2)] in a range of 0.3 to 5.0 allows the flawless surface of a polished substance to be efficiently obtained and additionally the surface of a polished substance with a greatly superior washing efficiency to be efficiently obtained.

Here, a polishing device to be used can involve a general polishing device having a surface plate on which a carrier for retaining a semiconductor substrate and an abrasive pad are stuck, and a pressurizing method is not particularly limited, involving a method of utilizing a carrier's own weight, a method of pressurizing with air, and the like.

In the case of (5), [(t1)/(t2)] is preferably 0.3 to 1.8, more preferably 0.4 to 1.5, which values of [(t1)/(t2)] is allowed by adjusting the rotational speed of a surface plate. [(p1)/(p2)] in a range of 0.2 to 2.0 allows the flawless surface of a polished substance to be efficiently obtained and additionally the surface of a polished substance with a greatly superior washing efficiency to be efficiently obtained.

With regard to a polishing method of the present invention, the thickness of a substrate to be polished and removed is not particularly limited in polishing in a second stage and further, preferably 30 to 200 nm, more preferably 40 to 160 nm, and particularly preferably 50 to 120 nm. The thickness in this range allows a flawless polished surface to be obtained at a practical rate in manufacturing a device.

In addition, with regard to a polishing method of the present invention, abrasive properties such that the outer periphery of a wafer also is uniformly stable can be developed by using an abrasive pad with concentric recessing or spiral recessing.

Further, with regard to a polishing method of the present invention, superior flattening properties can be stably developed by performing pad conditioning simultaneously with polishing for 10 % or more of polishing time, preferably 20 % or more, and particularly preferably 35 % or more. A pad conditioner is not particularly limited to the size and the particle diameter and form of fixed diamond, for which pad conditioner, for example, CMP-MC100A (manufactured by ASAHI DIAMOND INDUSTRIAL CO., LTD.) can be used.

Further, with regard to a polishing method of the present invention, in dropping an abrasive liquid for CMP process of the present invention into an abrasive pad, superior flattening properties can be stably developed by polishing while putting an abrasive head on the side of the rotational direction of an abrasive table with respect to a dropping position of the abrasive liquid and putting the dropping position of the abrasive liquid on the side of the rotational direction of the abrasive table with respect to a pad conditioner and immediately near the center of the pad with respect to the center of the abrasive head.

The inventors of the present invention have found out that the quality and quantity of the above-mentioned abrasive material and addition agent correlate greatly with abrasive properties, that is, the properties (flattening properties) such that only the height can be selectively polished without polishing the recess with a difference in level on the occasion of polishing a device wafer on which surface a pattern is formed.

According to the present invention, innumerable flaws are not left on a wafer after polishing, and the aggregation of an abrasive material by an addition agent is prevented, and additionally washing after polishing can be easily performed so as to notably improve the efficiency percentage of a device wafer.

### (A Polished Material)

An abrasive liquid for CMP process and a polishing method of the present invention are appropriate for the processing of flattening the surface of a device wafer on which at least a silicon oxide film is formed, and are the most appropriate for the processing of flattening the surface of a semiconductor device comprising a layer insulation film or an element separation film, a magnetic head and a substrate for a liquid crystal display in the semiconductor industry.

A layer insulation film and an element separation film polished by using an abrasive liquid for CMP process of the present invention are superior in flatness of the surface thereof and facilitate the multilayering of wiring. Also, a semiconductor device comprising these layer insulation film and element separation film or a magnetic head has a superior performance of electrical properties.

### BEST MODE FOR CARRYING OUT THE INVENTION

The present invention is further described hereinafter by examples and is not limited thereto. Hereinafter, part and % denote part by weight and weight % respectively.

### Manufacturing Example 1

1,000 g of 0.1 %-sodium silicate aqueous solution was passed through a column of 1,000 g of cation exchange resin (DIAION SK1B; manufactured by MITSUBISHI CHEMICAL CORPORATION) and thereafter stirred at a temperature of 50°C for 3 hours to obtain silica sol, which was cooled to room temperature to thereafter obtain slurry (1) having a silica concentration of 30 % by vacuum dewatering and concentration at 35°C.

### Manufacturing Example 2

360 ml of toluene, 10.8 g of sorbitan monooleate, 120 ml of ion exchange water and 1 ml of acetic acid were charged into a glass reaction vessel with a 1L-agitator and vehemently stirred at a temperature of 50°C for 10 minutes to emulsification. 140 ml of tetraethoxysilane was projected thereinto at a stroke and reacted at a temperature of 50°C for 3 hours to obtain silica sol. After being cooled to room temperature, this silica sol was filtered with filter paper (No. 2), which silica sol on the filter paper was washed by 1L of each of methanol and ion exchange water in this order and thereafter dispersed into ion exchange water to obtain slurry (2) having a silica concentration of 30 %.

### Manufacturing Example 3

Similarly to Manufacturing Example 1, 1,000 g of 0.1 %-sodium silicate aqueous solution was passed through a column of 1,000 g of cation exchange resin (DIAION SK1B; manufactured by MITSUBISHI CHEMICAL CORPORATION) and thereafter stirred at a temperature of 65°C for 5 hours to obtain silica sol, which was cooled to room temperature to thereafter obtain slurry (3) having a silica concentration of 30 % by dewatering and concentration in the same manner as Manufacturing Example 1.

### Example 1 (Abrasive Liquid A)

1,000 g of the slurry (1) and 13.4 g of 30 %-aqueous ammonia were projected into a planetary mixer and stirred for 15 minutes to obtain an abrasive liquid A for CMP process.

### Example 2 (Abrasive Liquid B)

1,000 g of the slurry (2) and 33.5 g of 30 %-aqueous ammonia were projected into a planetary mixer and stirred for 15 minutes to obtain an abrasive liquid B for CMP process.

### Example 3 (Abrasive Liquid C)

1,000 g of the slurry (1) and 40.0 g of hexamethylenediamine were projected into a planetary mixer and stirred for 15 minutes to obtain an abrasive liquid C for CMP process.

### Comparative Example 1 (Abrasive Liquid D)

1,000 g of the slurry (3) and 33.5 g of 30 %-aqueous ammonia were projected into a planetary mixer and stirred for 15 minutes to obtain an abrasive liquid D for CMP process.

### Comparative Example 2 (Abrasive Liquid E)

1,000 g of the slurry (1) and 4.0 g of potassium hydroxide were projected into a planetary mixer and stirred for 15 minutes to obtain an abrasive liquid E for CMP process.

### Comparative Example 3 (Abrasive Liquid F)

A commercial abrasive liquid for CMP process 'SS-25' (manufactured by CABOT MICROELECTRONIC COR.) was regarded as an abrasive liquid F for CMP process.

### Comparative Example 4 (Abrasive Liquid G)

Cerium carbonate hydrate was fired in air and dry-ground by using a jet mill to obtain cerium oxide, which was dispersed into water by using a planetary mixer to prepare an abrasive liquid G for CMP process having an abrasive material concentration of 1 weight %.

### Comparative Example 5 (Abrasive Liquid H)

Aluminum hydroxide was melted in an electric furnace to obtain alumina, which was dispersed into water by using a planetary mixer. Subsequently, ammonium polyacrylate (weight average molecular weight: 30,000), being 1 % with respect to the alumina in weight percentage, was added to this fluid dispersion to prepare an abrasive liquid H for CMP process having an abrasive material concentration of 5 weight %.

### <Evaluation 1: the measurement of abrasive material concentration with the particle diameter as the parameter >

With regard to the prepared abrasive liquids A to H for CMP process, central particle diameter and abrasive material concentration (weight %) in a range of a particle diameter in the abrasive liquids such as 20 to 80 nm, 30 to 70 nm and 40 to 60 nm were measured by using a particle-size distribution measuring device CHDF-2000. The results are shown in Table 1.

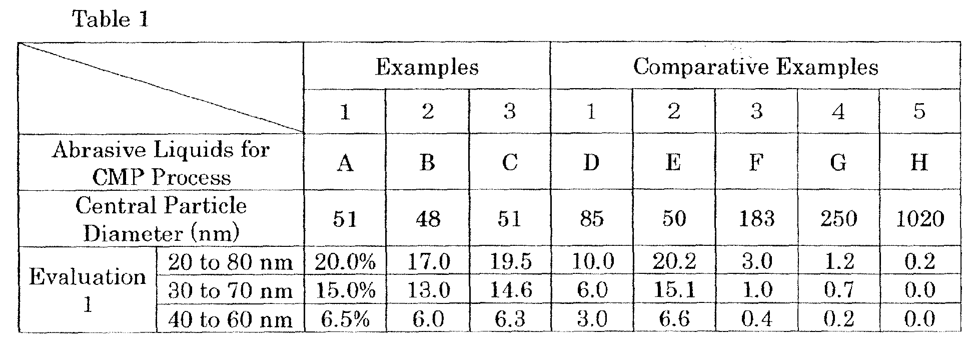

### <Evaluation 2: the flattening properties 1>

The polishing test of a patterned wafer having irregularities on a surface thereof was performed in accordance with the following polishing conditions 1; the case of using abrasive liquids A to C for CMP process was regarded as Examples 4 to 6 respectively, and the case of using abrasive liquids D to F for CMP process was regarded as Comparative Examples 6 to 8 respectively. A patterned wafer SKW 7-2 (manufactured by SKW INC COR.) was used as a substance to be polished. The polishing was performed by using a single-sided polishing machine MAT-ARW 681 (manufactured by MATEC APPLIED SCIENCES COR.)

### Polishing Conditions 1

The polishing at a first stage was performed on the polishing conditions such as an abrasive head pressure in polishing of 40 kPa, an abrasive head rotational speed of 58 rpm, a rotational speed of an abrasive surface plate of 60 rpm, an abrasive liquid flow rate of 200 ml/minute and a polishing time of 1 minute, and subsequently the polishing at a second stage was performed by using an abrasive liquid such that an abrasive liquid used in the polishing at a first stage is diluted with ion exchange water by 1.5 times on the polishing conditions such as an abrasive head pressure in polishing of 50 kPa, an abrasive head rotational speed of 95 rpm, a rotational speed of an abrasive surface plate of 100 rpm, an abrasive liquid flow rate of 200 ml/minute and a polishing time of 15 seconds.

This polishing was performed while putting an abrasive head on a side of a rotational direction of an abrasive table with respect to a dropping position of the abrasive liquid and putting the dropping position of the abrasive liquid on a side of a rotational direction of the abrasive table with respect to a pad conditioner and immediately near a center of the pad with respect to a center of the abrasive head.

IC 1000 (050) K-Groove/Suba 400 (manufactured by RODEL COR.) with concentric recessing was used for the abrasive pad.

Also, pad conditioning was performed simultaneously with polishing at a pressure of 20 kPa and a rotational speed of 20 rpm. CMP-MC100A (manufactured by ASAHI DIAMOND INDUSTRIAL CO., LTD.) was used for a pad conditioner.

### <Evaluation 2: the flattening properties 2>

Next, a patterned wafer SKW 7-2 (manufactured by SKW INC COR.) was polished by using an abrasive liquid A for CMP process on the following polishing conditions 2 to 5, which were regarded as Examples 7 to 10 respectively.

### Polishing Conditions 2

The totally same polishing conditions as Polishing Conditions 1 except for replacing an abrasive liquid in the polishing at a second stage, such that an abrasive liquid used at a first stage is diluted, with an abrasive liquid G for CMP process were regarded as Polishing Conditions 2.

### Polishing Conditions 3

The totally same polishing conditions as Polishing Conditions 1 except for replacing an abrasive liquid in the polishing at a second stage, such that an abrasive liquid used at a first stage is diluted, with an abrasive liquid D for CMP process were regarded as Polishing Conditions 3.

### Polishing Conditions 4

The totally same polishing conditions as Polishing Conditions 1 except for replacing an abrasive head pressure of 50 kPa in the polishing at a second stage with 80 kPa were regarded as Polishing Conditions 4.

### Polishing Conditions 5

The totally same polishing conditions as Polishing Conditions 1 except for replacing a table rotational frequency of 100 rpm in the polishing at a second stage with 120 rpm were regarded as Polishing Conditions 5.

Similarly, a patterned wafer SKW 7-2 (manufactured by SKW INC COR.) was polished by using an abrasive liquid A for CMP process on the following polishing conditions 6 to 13, which were regarded as Comparative Examples 9 to 16 respectively.

### Polishing Conditions 6

The totally same polishing conditions as Polishing Conditions 1 except for not performing the polishing at a second stage were regarded as Polishing Conditions 6.

### Polishing Conditions 7

The totally same polishing conditions as Polishing Conditions 1 except for replacing an abrasive liquid in the polishing at a second stage, such that an abrasive liquid used at a first stage is diluted, with an abrasive liquid H for CMP process were regarded as Polishing Conditions 7.

### Polishing Conditions 8

The totally same polishing conditions as Polishing Conditions 1 except for replacing an abrasive head pressure of 50 kPa in the polishing at a second stage with 150 kPa were regarded as Polishing Conditions 8.

### Polishing Conditions 9

The totally same polishing conditions as Polishing Conditions 1 except for replacing a table rotational frequency of 100 rpm in the polishing at a second stage with 20 rpm were regarded as Polishing Conditions 9.

### Polishing Conditions 10

The totally same polishing conditions as Polishing Conditions 1 except for placing the dropping position of slurry on the outside of the center of the abrasive head were regarded as Polishing Conditions 10.

### Polishing Conditions 11

The totally same polishing conditions as Polishing Conditions 1 except for conversely placing the head position, the conditioner and the dropping position of slurry were regarded as Polishing Conditions 11. Polishing Conditions 12

The totally same polishing conditions as Polishing Conditions 1 except for replacing the abrasive pad with IC 1000 (050) Perforate/Suba 400 were regarded as Polishing Conditions 12.

### Polishing Conditions 13

The totally same polishing conditions as Polishing Conditions 1 except for not performing the pad conditioning during polishing were regarded as Polishing Conditions 13.

All patterned wafers polished in Evaluation 2 were sufficiently washed with a PVA brush in 0.5 %-hydrofluoric acid aqueous solution and ultrapure water so as to be thereafter dried while shaking off waterdrops adhering to a semiconductor substrate by using a spin drier, and the height and the recess at seven spots in a ratio in line width of the height to the recess such as 10:90, 30:70, 40:60, 50:50, 60:40, 70:30 and 90:10 were measuring points in five dies in total existing at the center of the wafers, a half radius at 6 o'clock position, a half radius at 9 o'clock position, a half radius at 12 o'clock position and the edge at 3 o'clock position, and then an average value of film thickness difference between the height with the thickest film thickness and the recess with the thinnest film thickness was calculated as a remaining difference in level of the wafers by using an optical interference type film thickness measuring machine (NanoSpec/AFT 6100A manufactured by NANOMETRICS JAPAN LTD.). The results determined by the following standard were shown in Table 2.
⊚: less than 2000 Å
○: 2000 Å or more and less than 3000 Å
△: 3000 Å or more and less than 5000 Å
×: 5000 Å or more

### <Evaluation 3: the number of remaining abrasive material aggregates and the number of flaws>

Also, all patterned wafers polished in Evaluation 2 were observed for the number of remaining abrasive materials and the number of flaws on the wafers by polishing with the use of Surfscan AIT1 and Review SEM eV300 (both manufactured by KLA-TENCOR LTD.). The number of remaining abrasive materials aggregates and flaws of 0.2 µm or more existing on the wafers was calculated and determined by the following standard so as to be shown in Table 2.
⊚: less than 10 pieces
○: 10 pieces or more and less than 20 pieces
△: 20 pieces or more and less than 30 pieces
×: 30 pieces or more

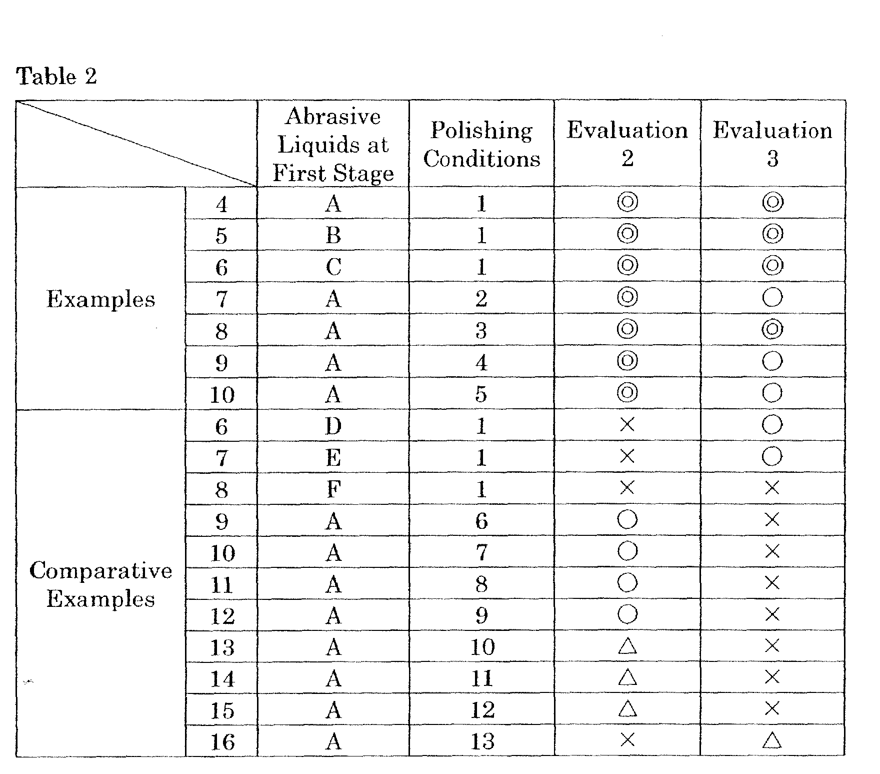

It is understood from the results of Table 2 that the employment of a polishing method of the present invention brings a superior polishing performance (flattening performance) and a superior finish of a wafer surface with less remaining abrasive materials aggregates and flaws.

### INDUSTRIAL APPLICABILITY

An abrasive liquid for CMP process of the present invention takes effect of notably superior polishing performances (such as flattening performance, low flaw properties and high washing properties) as compared with a conventionally used abrasive liquid for CMP process. Also, the employment of a polishing method of the present invention takes effect of obtaining a polished substance having a flawless wafer surface with a superior finish.

Accordingly, an abrasive liquid for CMP process and a polishing method are appropriate for the processing of flattening the surface of a device wafer on which at least a silicon oxide film is formed, and are the most appropriate for the processing of flattening the surface of a semiconductor device comprising a layer insulation film or an element separation film, a magnetic head and a substrate for a liquid crystal display in the semiconductor industry.

## Claims

1. An abrasive liquid for CMP process comprising:
an abrasive material;
an aqueous solvent; and
an addition agent;
and containing abrasive particles having a particle diameter of 20 to 80 nm by 15 weight % or more on a basis of a weight of the abrasive liquid.

2. The abrasive liquid for CMP process according to Claim 1, wherein said addition agent is a basic substance having a pKa of 7 to 11 at a temperature of 25 °C.

3. The abrasive liquid for CMP process according to Claim 1, wherein said addition agent is fatty amine having a primary amino group and/or ammonia.

4. The abrasive liquid for CMP process according to Claim 1, wherein a content of said addition agent is 0.01 weight % or more on a basis of a weight of the abrasive liquid.

5. The abrasive liquid for CMP process according to Claim 1, wherein said abrasive material is an inorganic substance of one kind or two kinds or more selected from a group consisting of silicon dioxide, aluminum oxide, cerium oxide, silicon nitride, and zirconium oxide.

6. The abrasive liquid for CMP process according to Claim 1, wherein said abrasive material is colloidal silica.

7. A method of polishing a device wafer by using an abrasive liquid for CMP process comprising an abrasive material, an aqueous solvent and an addition agent, and containing abrasive particles having a particle diameter of 20 to 80 nm by 15 weight % or more on a basis of a weight of the abrasive liquid.

8. The method of polishing according to Claim 7, wherein a surface of said device wafer to be polished is formed of a film comprising at least silicon oxide.

9. The method of polishing said device wafer, comprising the step of polishing by two stages or more with polishing conditions changed;
wherein the method of polishing according to Claim 7 is used at any of the stages.

10. The method of polishing according to Claim 9, wherein the step of polishing in a second stage and further is performed under one or two conditions or more among the following conditions:
(1) to differentiate a quality of an abrasive material to be used between a first stage and a second stage and further;
(2) to use an abrasive liquid, such that an abrasive liquid at a first stage is diluted by 1.1 to 100 times, as an abrasive liquid in a second stage and further;
(3) to make into 0.1 to 10.0 a ratio [(r1)/(r2)] of an average particle diameter (r1) of an abrasive material used at a first stage to an average particle diameter (r2) of an abrasive material used in a second stage and further;
(4) to make into 0.3 to 5.0 a ratio [(p1)/(p2)] of a pressure (p1) applied on a semiconductor substrate in polishing at a first stage to a pressure (p2) applied on a semiconductor substrate in polishing in a second stage and further; and
(5) to make into 0.2 to 2.0 a ratio [(t1)/(t2)] of a rotational speed (t1) of a surface plate in polishing at a first stage to a rotational frequency (t2) of a surface plate in polishing in a second stage and further.

11. The method of polishing according to Claim 7, wherein an abrasive pad with concentric recessing or spiral recessing is used.

12. The method of polishing according to Claim 7, wherein pad conditioning is performed simultaneously with polishing for 10 % or more of polishing time.

13. The method of polishing according to Claim 7, wherein, in dropping an abrasive liquid for CMP process into an abrasive pad, polishing is performed while putting an abrasive head on a side of a rotational direction of an abrasive table with respect to a dropping position of the abrasive liquid and putting the dropping position of the abrasive liquid on a side of a rotational direction of the abrasive table with respect to a pad conditioner and immediately near a center of the pad with respect to a center of the abrasive head.

14. A layer insulation film or an element separation film obtained by polishing with a use of an abrasive liquid for CMP process according to Claim 1.

15. A semiconductor device comprising a layer insulation film or an element separation film according to Claim 14.

16. A magnetic head or a substrate for a liquid crystal display obtained by polishing with a use of an abrasive liquid for CMP process according to Claim 1.
